# EUROPEAN PATENT SPECIFICATION

(11) **EP 1 428 267 B1**
(45) Date of publication and mention of the grant of the patent: **12.09.2012**
(21) Application number: 02765896.2
(22) Date of filing: 26.07.2002
(51) Int. Cl.: H01L 31/068, H01L 31/18, H01L 27/142

(54) **SOLAR CELL HAVING A BYPASS DIODE FOR REVERSE BIAS PROTECTION**
SOLARZELLE MIT BYPASSDIODE ZUM SCHUTZ GEGEN INVERSE VORSPANNUNG
CELLULE SOLAIRE COMPORTANT UNE DIODE EN PARALLELE DE PROTECTION CONTRE LES POLARISATIONS INVERSES

(30) Priority: 27.07.2001 US 308503 P
(43) Date of publication of application: 16.06.2004
(73) Proprietor: Emcore Solar Power, Inc., Albuquerque NM 87123 (US); Chaw-Long, Chu, Chino Hills, CA (US)
(72) Inventor: CHAW-LONG, Chu, Chino Hills, CA (US)
(74) Representative: Wagner & Geyer
(86) International application number: PCT/US2002/023978
(87) International publication number: WO 2003/012880

(56) References cited:
- EP-A- 1 056 137
- WO-A-00/21138
- US-A- 6 103 970
- US-B1- 6 252 287

## Description

### BACKGROUND OF THE INVENTION

### Field of the Invention

The present invention relates to semiconductor devices. More specifically, the present invention relates to apparatuses of solar cells.

### Description in the Related Art

Photovoltaic cells, commonly called solar cells, are well-known devices which convert solar energy into electrical energy. Solar cells have long been used to generate electrical power in both terrestrial and space applications. Solar cells offer several advantages over more conventional power sources. For example, solar cells offer a clean method for generating electricity. Furthermore, solar cells do not have to be replenished with fossil fuels. Instead, solar cells are powered by the virtually limitless energy of the sun. The solar cell is a particularly attractive device for generating energy in space, where low-cost conventional power sources are unavailable.

Solar cells are typically assembled into arrays of solar cells connected together in series, or in parallel, or in a series-parallel combination. The desired output voltage and current, at least in part, determine the number of cells in an array, as well as the array topology.

When all cells in an array are illuminated, each cell will be forward biased. However, if one or more of the cells is shadowed (i.e., not illuminated), by a satellite antenna or the like, the shadowed cell or cells may become reversed biased because of the voltage generated by the unshadowed cells. Reverse biasing of a cell can cause permanent degradation in cell performance or even complete cell failure. To guard against such damage, it is customary to provide protective bypass diodes. One bypass diode may be connected across several cells, or for enhanced reliability, each cell may have its own bypass diode. Multijunction solar cells are particularly susceptible to damage when subjected to reverse bias condition. Thus, multijunction cells in particular benefit from having the bypass diode protection.

Conventionally, a bypass diode is connected in an anti-parallel configuration, with the anode and the cathode of the bypass diode respectively connected to the cathode and the anode of the solar cell, so that the bypass diode will be reversed biased when the cells are illuminated. When a cell is shadowed, current through the shadowed cell becomes limited and the shadowed cell becomes reverse biased. The bypass diode connected across the shadowed cell in turn becomes forward biased. Most of the current will flow through the bypass diode rather than through the shadowed cell, thereby allowing current to continue flowing through the array. In addition, the bypass diode limits the reverse bias voltage across the shadowed cell, thereby protecting the shadowed cell.

Several different conventional methods have been used to provide solar cells with bypass diode protection. Each conventional method has its drawbacks. For example, in an attempt to provide increased bypass protection, one method involves locating a bypass diode between adjacent cells, with the anode of the bypass diode connected to one cell and the cathode of the diode connected to an adjoining cell. However, this technique typically requires that the cells be assembled into an array before the bypass diode protection can be added. This assembly method is difficult and inefficient. Furthermore, this technique requires the bypass diodes to be added by the array assembler, rather than the cell manufacturer. In addition, this technique requires the cells to be spaced far enough apart so as to accommodate the bypass diode. This spacing results in the array having a lower packing factor, and thus, the array is less efficient on the area basis.

Another conventional technique providing a bypass diode for each cell requires that a recess be formed on the back of the cell in which a bypass diode is placed. Each cell is provided with a first polarity contact on a front surface of the cell and a second polarity contact is provided on a back surface of each cell. An "S" shaped interconnect must then be welded from a back surface contact of a first cell to a front surface contact of an adjoining cell. Thus, this technique disadvantageously requires the cells to be spaced far enough apart to accommodate the interconnect which must pass between the adjoining cells. Additional disadvantages of this method include the possibility of microcracks generated during formation of the recess. In addition, this technique requires a thick bondline of adhesive, thereby adding stress-risers, increasing stresses generated during temperature cycling. Furthermore, the conventional technique requires the connection of the interconnect to the adjoining cell to be performed by the array assembler as opposed to the cell manufacturer.

Thus, what is needed is a more efficient mechanism for providing reverse bias protection to a solar cell.

EP 1056137 discloses a solar cell with an integral Schottky by pass diode.

### SUMMARY OF THE INVENTION

In accordance with the present invention a semiconductor device as set forth in claim 1 is provided. Preferred embodiments of the invention are disclosed in the dependent claims.

Additional features and benefits of the present invention will become apparent from the detailed description, figures and claims set forth below.

### BRIEF DESCRIPTION OF THE DRAWINGS

The present invention will be understood more fully from the detailed description given below and from the accompanying drawings of various embodiments of the invention, which, however, should not be taken to limit the invention to the specific embodiments, but are for explanation and understanding only.
Figure 1 illustrates the layers of a multijunction solar cell structure formed over a substrate in accordance with one embodiment of the present invention;
Figure 2 illustrate a first processing step for forming a solar cell with protection against reverse biasing, showing a photoresist layer formed over the multijunction solar cell structure of Figure 1;
Figure 3 illustrates a second processing step for forming a solar cell with protection against reverse biasing, showing a trough formed through the multijunction solar cell structure of Figure 2 extending to the front surface of the substrate;
Figure 4 illustrates a third processing step for forming a solar cell with protection against reverse biasing, showing the photoresist layer of Figure 3 removed and a n-type doped island isolated within the trough;
Figure 5 illustrates a fourth processing step for forming a solar cell with protection against reverse biasing, showing contacts formed on the structure;
Figure 6 illustrates a fifth processing step for forming a solar cell with protection against reverse biasing, showing a back cell contact formed on the back surface of the substrate;
Figure 7 illustrates a sixth processing step for forming a solar cell with protection against reverse biasing, showing a jumper bar connecting a front cell contact and a diode contact, and a second interconnect connecting the island with a p-type portion of the substrate;
Figure 8 illustrates an alternative embodiment of a solar cell with protection against reverse biasing, showing the metallic interconnects formed over insulator layers;
Figure 9 illustrates a solar cell with protection against reverse biasing help full in understanding the invention but showing a Schottky diode formed in a recess on the back surface of the solar cell structure;
Figure 10 illustrates a series of interconnected solar cell structures having Schottky diode protection when solar cells are exposed to light; and
Figure 11 illustrates a series of interconnected solar cell structures having Schottky diode protection when the cells are shadowed.

### DETAILED DESCRIPTION

Solar cells having diodes for reverse bias protection.

For purposes of explanation, various specific details are set forth to provide a thorough understanding of the present invention. It will be apparent, however, to one skilled in the art that these specific details may not be required to practice the present invention. In other instances, well-known devices are shown in block diagram form to avoid obscuring the present invention.

It should be understood that the present invention may contain circuits that can be manufacturable using well-known CMOS ("complementary metal-oxide semiconductor) technology, or other semiconductor manufacturing processes. In addition, the present invention may be implemented with other manufacturing processes for making digital devices.

In one embodiment, a multijunction solar cell circuit uses Schottky diodes as bypass diodes for providing reverse bias protection. A Schottky diode is formed at the interface between a metallic diode contact and a semiconductor substrate on which the solar cell is grown. In another embodiment, the solar cell is a multijunction cell formed from at least group III, IV, or V materials. The solar cell includes a Ge substrate, which may further include a photoactive junction. In this embodiment, a Schottky diode is provided in a trough or recess extending through the solar cell layers to a doped region on the front surface of the substrate. The Schottky diode is electrically connected across some or all of the cells of the solar cell structure with a jumper bar or other suitable interconnect. In yet another example not part of the invention, the Schottky diode is provided on a back surface of the substrate, with a C-clamp interconnecting at least one solar cell contact to the diode contact.

In another example not part of the invention, a solar cell structure comprises a substrate having a front surface and a back surface, the substrate selected to have a least a portion thereof forming part of a Schottky diode. A multijunction solar cell structure includes at least a first photovoltaic cell having a first photoactive junction therein and a second photovoltaic cell having a second photoactive junction therein overlaying at least a portion of the first photovoltaic cell. A Schottky diode is electrically connected across the at least first and second photovoltaic cells to protect the at least first and said second photovoltaic cells against reverse biasing. The Schottky diode is formed at least in part from the substrate and a diode contact formed over the substrate.

In yet another embodiment, a solar cell structure having protection against reverse biasing comprises a substrate having a front surface and a back surface and at least one photovoltaic cell over the front surface of the substrate. A front contact is applied over the at least one photovoltaic cell, and a back contact is applied over the back surface of the substrate. A trough extends through the at least one photovoltaic cell to expose at least a portion of the front surface of the substrate. A diode is formed over the exposed portion of the front surface of the substrate in the trough. The diode contact and the substrate together form a Schottky diode in the trough, which is electrically connected across the at least one photovoltaic cell.

In another example not part of the invention, the solar cell structure comprises a substrate having a front surface and a back surface and at least one photovoltaic cell over the front surface of the substrate. A front contact is applied over the at least on photovoltaic cell, and a back contact is applied over the back surface of the substrate. A recess extends through the back contact to expose the back surface of the substrate. A diode contact is applied over the back surface of the substrate in the recess. The diode contact and the back surface of the substrate together form a Schottky diode in the recess which is electrically connected across the at lest one photovoltaic cell. In one embodiment, this electrical connection is formed with a C-clamp that connects the diode contact to the front contact.

A method of manufacturing a protected multijunction solar cell circuit is provided. A substrate is selected having a front surface and a back surface, the substrate having at least a portion thereof capable of forming a Schottky diode. A multijunction solar cell structure is formed over at least a portion of the front surface of the substrate. The multijunction solar cell structure includes at least a first photovoltaic cell having a first photovoltaic junction therein and a second photovoltaic cell having a second photoactive junction therein overlaying at least a portion of the first photovoltaic cell. A diode contact is formed over the substrate to form a Schottky diode at the interface between the diode contact and the substrate. The Schottky diode is electrically connected across the at least first and second photovoltaic cells to protect the at least first and said second photovoltaic cells against reverse biasing.

As discussed above, the solar cell may be a single junction or multijunction solar cell. In one embodiment, a bypass diode is provided on a multijunction solar cell structure, which may be a Schottky diode formed at the connection of a metallic contact and a semiconductor substrate. The solar cell/bypass diode device may be interconnected with other solar cells to form series and/or parallel strings of solar cells. The strings may be further connected to form a reliable and robust solar cell array. The solar cell array in one embodiment may be mounted to a space vehicle, thereby providing power to the space vehicle.

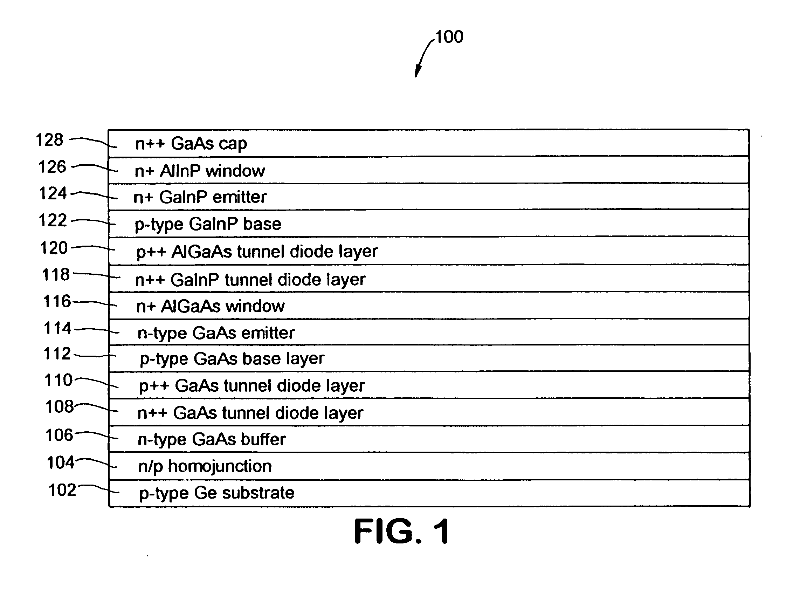

Figure 1 shows a sequence of III-V layers 104-128 which are grown sequentially on a Ge substrate 102 in one embodiment of the present invention to form a multijunction solar cell structure 100. The Ge substrate 102 may further include a photoactive junction. In one embodiment, the layers are epitaxially grown, meaning that they replicate the single crystalline structure of material. The growth parameters (deposition temperature, growth rate, compound alloy composition, and impurity dopant concentrations) are selected to provide layers with the desired electrical qualities and thickness, to thereby obtain the desired overall cell performance. The epitaxial techniques which may be used to grow the cell layers include, by way o example, MOCVD (metal-organic chemical vapor deposition) epitaxy, sometimes called OMVPE (organic-metal vapor phase epitaxy), MBE (molecular beam epitaxy), and MOMBE (metal-organic molecular beam epitaxy).

In the illustrated embodiment, a GaAs buffer layer 106 is grown over at least a portion of the substrate 102. At the interface between layer 102 and layer 106 a photoactive junction is formed, constituting the lower cell of the solar cell structure. In the embodiment shown, when a p-type Ge substrate 102 is used, the diffusion of As form the n-type layer 106 forms an n/p homojunction 104 in the substrate 102. In another embodiment, when a n-type Ge substrate is used, the photoactive junction is an n+GaAs/n+Ge heterodiode.

As illustrated in Figure 1, a highly n doped GaAs layer 108 and a highly p doped GaAs layer 110 are grown over at least a portion of the GaAs buffer layer 106. The combined layers 108 and 110 function as a tunnel diode. A p-type GaAs layer 112 is grown on the tunnel diode layer 110, and an n-type GaAs emitter layer 114 is formed over the base layer 112. The base layer 112 and the n type emitter layer 114 together form a middle cell stage. A highly n doped AlGaAs window layer 116 overlays the emitter layer 114. A tunnel diode, including very highly doped n-type GaInP and p-type AlGaAs layers 118, 120, is grown over the window layer 116. An upper cell stage, including a p doped base layer 122 is a highly n doped emitter layer 124, is formed over the tunnel diode. The upper cell base layer and emitter layer are formed of GaInP.

In one embodiment, the last two layers grown for the solar cell are respectively a highly n doped AlInP window layer 126 and a highly n-doped GaAs cap layer 128. The window layer 126 is a thin layer of wide band gap material that passivates (reduces carrier recombination) the surface onto which the front surface ohmic contacts are deposited. In one embodiment, the contacts are in grid-tinger form, to balance low electrical resistance and high optical transparency. However, other contact patterns may be used as well. Formation of these contacts is described below.

It will be understood by one of ordinary skill in the art, that the three cells, three-junction, solar cell structure 100, illustrated in Figure 1, is only one of may possible cell embodiments which can be used. In another embodiment, a complementary structure, with the polarities of one or more layers switched (i.e., n doped layers are, instead, p doped, and p doped layers are, instead, n doped) may be used. For example, the cell and diode configurations illustrated in the figures and discussed below, can be changed from n/p to p/n. Also, the doping concentrations or layer thicknesses may be varied. Furthermore, in other embodiments, the solar cell structure 100 may include four or more photovoltaic cells, or only one or two cells. Similarly, the solar cell structure may alternatively include only one junction or two or more junctions. By way of example, in one embodiment, the cell structure 100 may include four junctions. It will also be appreciated that the term "formed over" as used herein does not limit a layer to being formed directly on top of another layer, and thus, a structure having a layer "formed over" another layer can include one or more additional layers formed between the two layers.

Furthermore, the solar cell structure 100 may include cells made from other materials, including but not limited to AlGaAs or InP. In other embodiments, the substrate 102 may be formed using a variety of different materials. For example, the solar cell 100 may use other semiconductors, including but not limited to GaAs, Si, or InP for the substrate, rather than the Ge substrate 102 illustrated in Figure 1. Alternatively, insulating substrates, such as sapphire, may be used. In one embodiment, the substrate 102 is a single crystal. If the solar cell structure 100 is intended for space use, such as on a space vehicle or satellite, then the cell materials are space-qualified for the appropriate space environment. For example, the solar cell structure 100 may be space qualified to operate in an AM0 radiation environment.

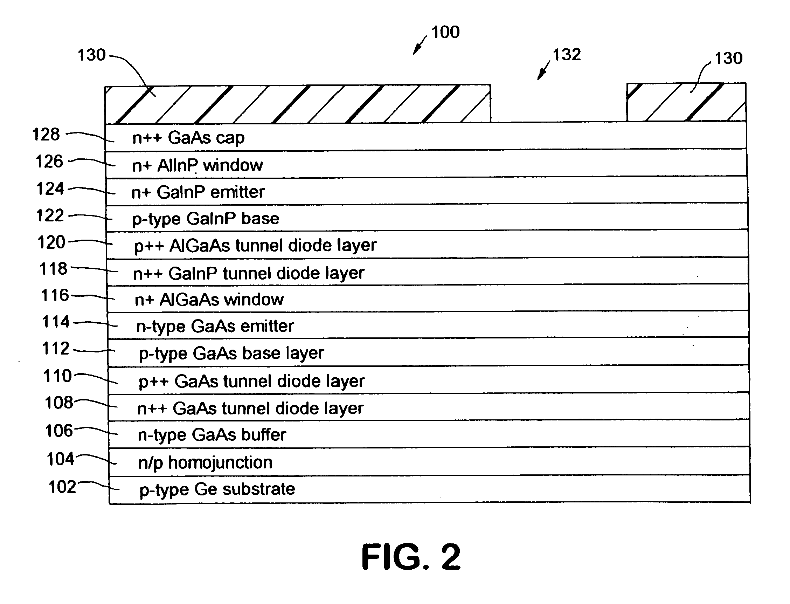

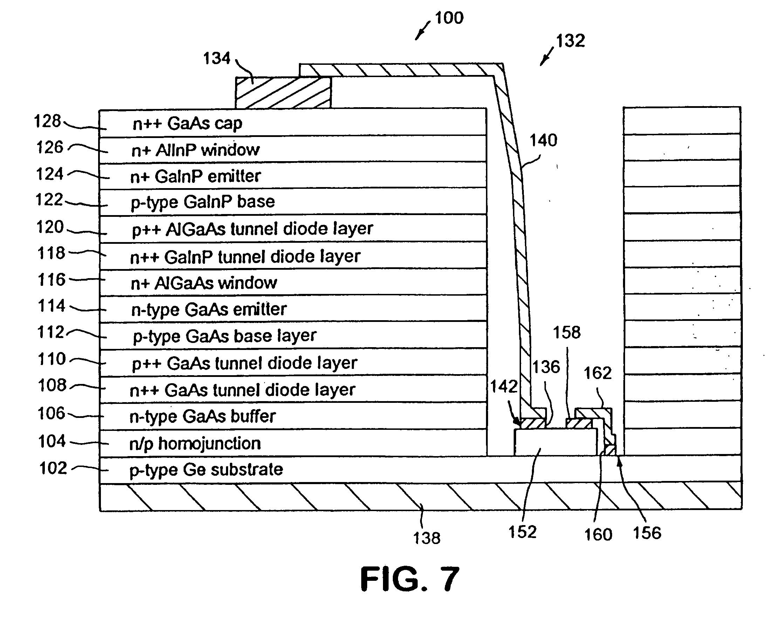

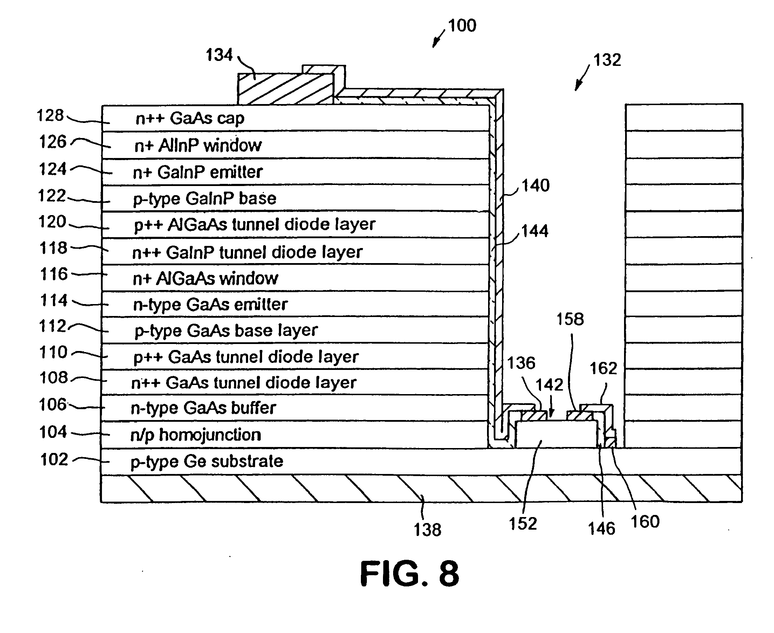

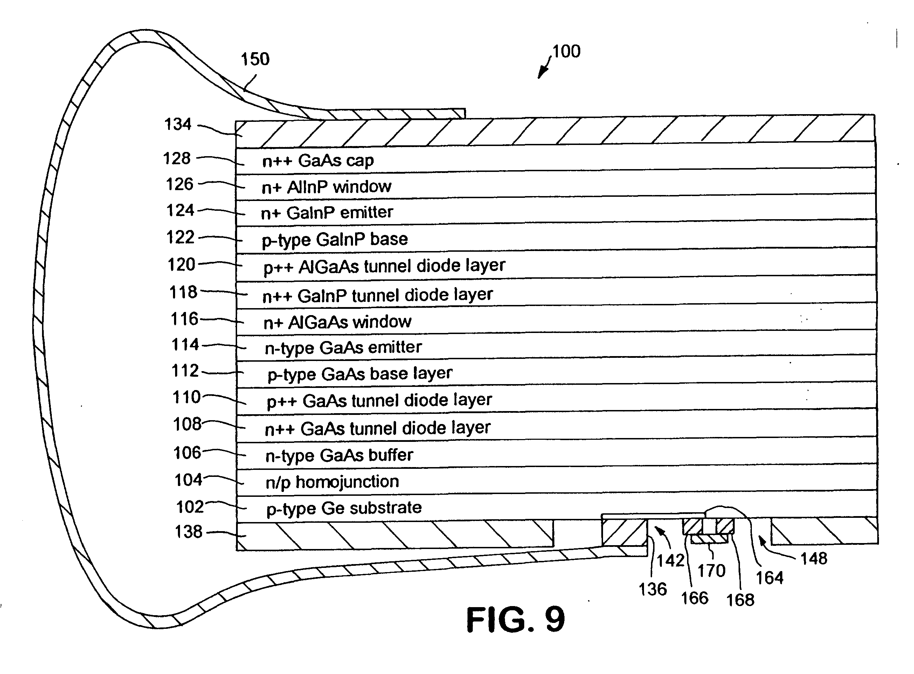

Solar cell structures incorporating bypass diode protection, and their associated methods of fabrication, will now be described. Figure 2-9 illustrate the formation of solar cell structures having a Schottky diode formed at the junction of the Ge substrate and a metallic contact formed on the Ge substrate. More particularly, Figures 7 and 8 describe embodiments in which the Schottky diode is formed in a trough or recess extending through the solar cell structure down to the upper surface of the substrate (i.e., the surface on which the solar cell is grown). Figure 9 describes an embodiment in which the Schottky diode is formed on the back surface of the substrate.

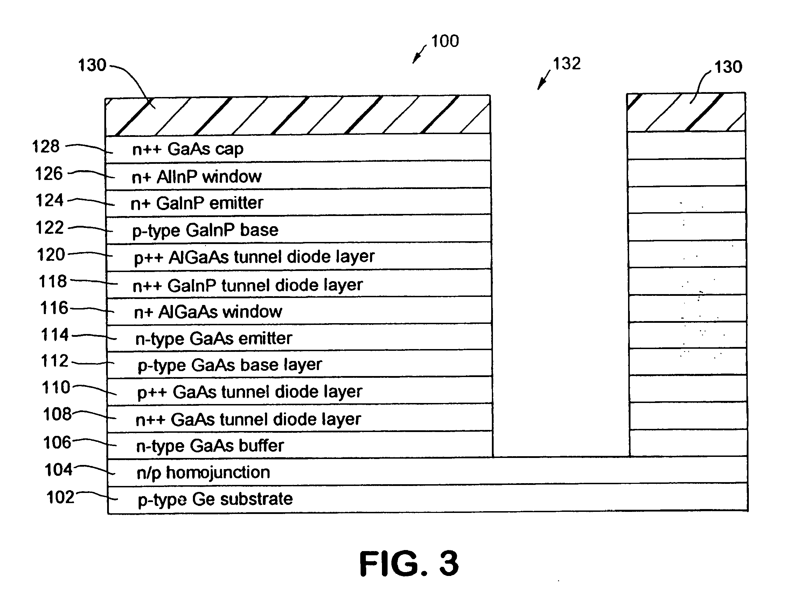

In one embodiment, the solar cell structure having bypass diode protection is formed by first epitaxially growing the layers shown in Figure 1 by conventional MOCVD and/or MBE technologies. As shown in Figure 2, portions of the front surface of the layers are then protected with a photoresist layer 130, which is exposed through a photomask (not shown) patterned to create open areas in the front surface of the structure. As shown in Figure 3, etching occurs through these open areas to form a trough 132 through the layers of the solar cell structure.

The etching process creates a trough 132 that extends down to the front surface of the n/p homojunction 104 in the germanium substrate 102, such that the exposed surface of the Ge substrate is in an arsenic doped region. In one embodiment, a etchant to remove layers 106-128 is HCl and a mixed acid comprising H₂SO₄, H₂O₂, and H₂O at a volume basis of (1:8:5). Also, an HBr etchant with a Br percentage greater than about 48% can be used to etch the epi-grown layers.

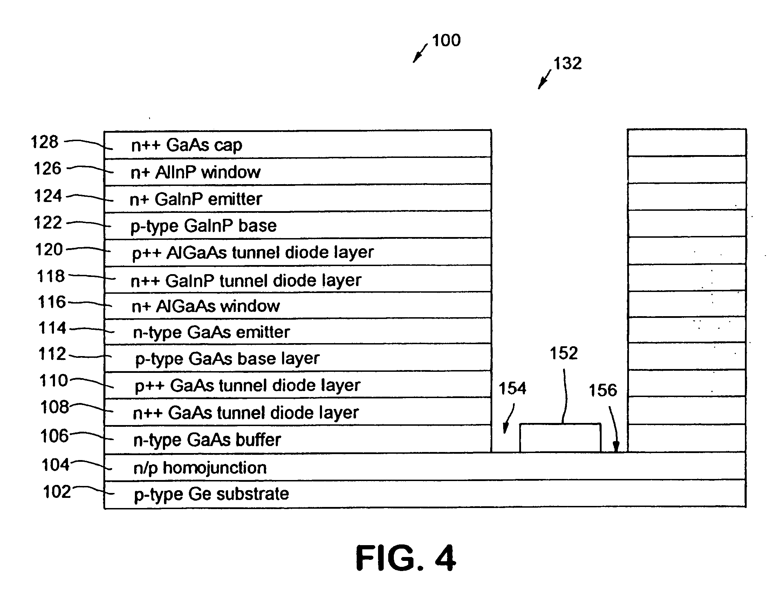

In the illustrated embodiment, portions of the n/p homojunction 104 formed in the Ge substrate 102 are next removed within the trough 132 with a photoresist layer (not shown) and by using a second etchant, a solution of HF/H₂O₂/H₂O prepared at various ratios. For example, the ratio can vary from (1:1:2) to (1:1:10) on a volume basis. The etching temperature can vary from about 20°C to about 35°C. As shown in Figure 4, this etching step leaves an island 152 in the trough 132, the island 152 being part of the Ge substrate 102. The front surface of the island 152 is n-type Ge, more As-doped germanium. A recess 154 surrounds the island 152, exposing portion a p-type 156 of the Ge substrate.

After masking to form the regions described above, the photoresist layers are removed using acetone to leave the structure solar cell structure shown in Figure 4. Microstripping techniques may be used to remove any residual photoresist left remaining after the acetone removal process. One the photoresist layer is removed, the contact fabrication process, including corresponding photoresist coating, baking, exposing, developing, metal evaporation, and lift off operations, can take place.

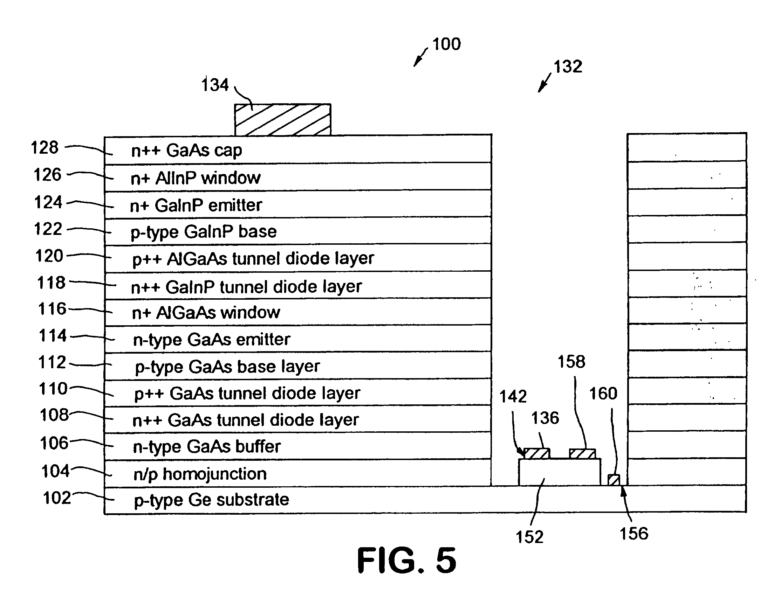

To form contacts on the structure, photoresist layers (not shown) are coated over the whole front surface of the structure, including in the trough 132. The photoresist layers are then baked and exposed with a photomask which leaves opened areas where contacts are to be deposited to the front surface of the Ge substrate 102 on the island 152, to a small region of the exposed n-doped GaAs layer cap layer 128, and to the p-type Ge substrate surface 156. Metals are evaporated into the exposed areas and over the remaining photoresist layer. As shown in Figure 5, a front cell contact 134 is thereby formed on the cap layer 128, and contacts 136 and 158 are formed on the front surface of the island 152 in the trough 132. A fourth contact 160 is provided on the exposed surface 156 of the p-type Ge substrate. The contact 136 is made of a titanium material or other types of materials such as, for example Ti/Pd/Ag, to facilitate the formation of a Schottky diode as described below. The contact 134 may similarly be made of titanium or other suitable material. The contact 158 is made of gold or other suitable material, and the contact 160 is made of gold, titanium or other suitable material.

In addition to these contacts, the photoresist also provides open slots to provide gridlines and bars/pad contacts to the cell. Next, a lift-off process is performed. The solar cell structure 100 is immersed in acetone, causing the photoresist to swell, and thereby breaks the metal film everywhere except on the regions designated to retain contacts, including contacts 134, 136, 158 and 160.

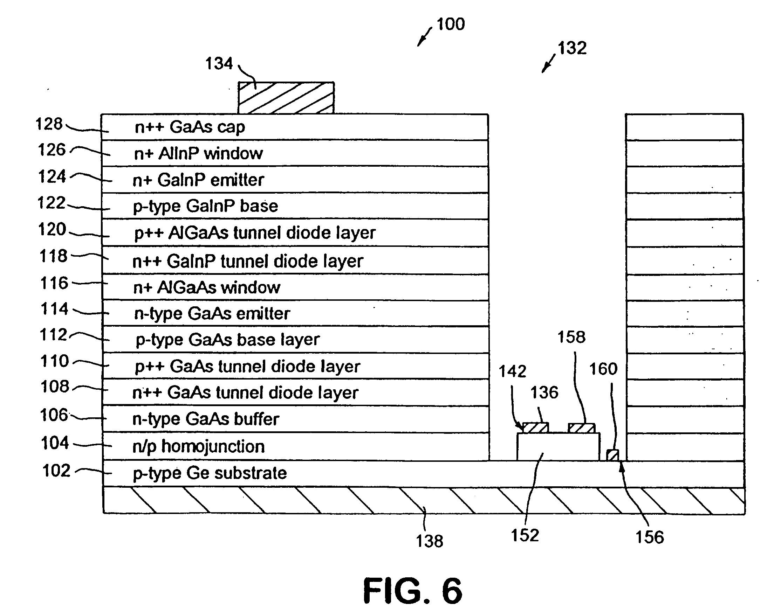

As shown in Figure 6, a back metal contact 138 is formed by evaporating a metallic material such as, for example Ag, over the back surface of the Ge substrate 102. The contacts 134, 136, 158, 160 and 138 are then heat-treated or sintered at about 400°C for about 5 minutes. Ohmic contacts are thereby formed between layer 134 and cap layer 128, and layer 138 and substrate 102. Ohmic contacts are also formed between the contact 158 and the n-type island 152, and the contact 160 and the p-type substrate 102. It will be appreciated that the contact 160 need not be provided on the front surface of the substrate, and therefore, could be provided at a p-type portion of the substrate on the back as well. A Schottky diode 142, described below, is formed between the As-doped Ge 152 and contact 136. A further processing step (not shown) may also include using the front contact metal 134 as an etch-mask, and etching the GaAs cap layer 128 off a major part of the exposed front surface. The cap layer 128 remains under the metallized areas, forming part of a low resistance contact mechanism. Using a resist mask to protect the front metallic area, on the rest of the surface an anti-reflecting layer may be deposited.

As shown in Figure 7, the solar cell structure 100 is completed by forming a first interconnect 162 between the contact 158 and the germanium substrate contact 160. It will be appreciated that the contact 158, the interconnect 162 and the contact 160 could be made from on piece of material. In one embodiment, the interconnects may be jumper bars made of a material such as silver, although other suitable materials, such as silver coated invar, covar or other alloys and metals may be used as well.

The interface of the metallic diode contact 136 and the As-doped semiconductor substrate 152 forms a Schottky diode 142. In one embodiment, the contacts are sintered at a temperature of about 400°C for about 5 minutes, although sintering temperatures in the range of about 350°C to 450°C can also be used. In another embodiment, sintering takes place at a temperature less than about 450°C in order to avoid formation of a high ohmic resistance contact between the contact 136 and the As-doped island 152. In one embodiment, after the metallic contacts are sintered, a second sintering step can be used to make the contacts stronger without damaging the diode characteristics. This second sintering takes place at 300°C for about 5 minutes. The Schottky diode provides protection against reverse biasing for the top, middle and bottom cells of the solar cell structure across which it is connected by the interconnects 140 and 162. It will be appreciated that the Schottky diode can also be formed to protect a fewer or greater number of cells. By proper interconnection, the Schottky diode can be used to protect both p/n and n/p solar cells.

It will be appreciated that, for one embodiment, the formation of the Schottky diode is facilitated by the selection of a highly As doped germanium substrate such as, for example, on the order of about 5 x 10¹⁶ cm⁻³ or higher. This doping can occur during n-type Ge ingot growth or by As diffusion during GaAs growth (for both n-type Ge and p-Type Ge). In the embodiment described above, the Ge substrate 102 is doped with Ga to make it p-type, and the following MOCVD process will diffuse high concentration As into the Ge substrate at layer 152. This layer of As-doped Ge 152 can generate a Schottky diode with the Ti alloy 136 used as a metal contact. For an n-type Ge substrate, if As is used as the n-type dopant, a Schottky diode can be formed by Ti alloy deposition without additional As diffusion. In one embodiment, the diode contacts are formed of a titanium material such as, for example, a Ti/Pd/Ag alloy. However, other metals or alloys, including but not limited to Ti/Au/Ag and Ti/Ge/Ni/Ag, can also form a Ge-Schottky diode.

Figure 8 illustrates another embodiment of a solar cell structure 100 similar to the embodiment of Figure 7. However, instead of using a jumper bar, the front cell contact 134 and the diode contact 136 are electrically connected with an interconnect 140 running along the walls of the trough 132. An insulating material 144, which may be a polyimide material, separates the metallic interconnect from the walls of the trough. Other materials, such Al₂O₃, TiOx, and other inorganic materials can also function as the insulator. For the connection 162 between the contact 158 and the p-type Ge contact 160, a second insulating material 146 can be used to separate the interconnect 162 from the walls of the island 152.

Figure 9 illustrates another design of a solar cell structure having bypass diode protection. In this design, a Schottky diode 142 is positioned on the back surface of the Ge substrate 102. To form this structure, the layers as shown in Figure 1 are first deposited. In one design, the Ge substrate is doped with As at the back surface, with doping occurring during ingot growth from residual GaAs inside the MOCVD chamber, or by a specific As diffusion step by turning the Ge wafer upside down. This forms as As-doped region 164 at the bottom surface of the substrate. Then, the front contact 134 is formed as described above, The back contact 138 is formed, with a mask protecting an area of the back surface of the Ge substrate 102 in order to form a recess 148.

To form the diode contact 136 in the recess 148, a photoresist layer is coated over the entire back surface, and is baked an exposed with a photomask to leave opened areas where the contact is to be deposited to the back surface of the substrate. In one embodiment, the metallic diode contact, which may be a titanium material or a Ti/Pd/Ag alloy, is evaporated into the exposed area and over the remaining photoresist layer. A lift-off process is used to remove the photoresist, by immersing the solar cell structure in acetone, causing the photoresist to swell, and thereby breaks the metal film everywhere except on the regions designated to retain the diode contact 136.

The interface of the metallic diode contact 136 and the Ge substrate 102 at As-doped region 164 forms a Schottky diode in the recess 148. In one embodiment, the back side metal contact 138 is Au/Ge/Ni/Ag, which will not form a Schottky diode with the Ge substrate. The Schottky diode 142 is electrically connected with the front contact using a C-clamp 150, which is made of Ag or other suitable material. Thus, the C-clamp electrically connects the diode across all of the photovoltaic cells.

A second contact 162 is provided on the back surface of the Ge substrate 102 to connect the n-type Ge substrate with the surrounding p-type Ge substrate. Thus, a contact 164 is formed on a p-type portion of the back surface, and an interconnect 170 is used to adjoin the contacts 166 and 168. As described above, the second contact on the As-doped portion of the germanium substrate, and the contact 168 may be made of titanium, gold or other suitable materials to form an ohmic contact with the p-type portion of the substrate.

A variety of other interconnect techniques may be used to connect the solar cell structure to the Schottky diodes discussed above. The final choice may depend on the additional complexity and the effect on cell yields and costs which results from the use of these alternative approaches.

Using at least some of the techniques described above, a solar cell incorporating a Schottky diode with cascaded cells has achieved efficiencies of well over 25%, and even over 27.0%. These efficiencies are comparable to conventional cascade cells lacking the Schottky diode. In one embodiment, a Schottky diode made with a Ge substrate has a forward bias voltage drop of approximately 0.3 to 0.6 volts when conducting 400 mA of forward current. Thus, compared to the forward voltage of an integrally formed GaAs bypass diode (1.6 V at 1 Isc and 2.1 V at 6 Isc), such as described in copending U.S. Patent Application Serial No. 09/314,597, filed May 19, 1999, the Ge diode generates less heat during operation. The leakage current of the Schottky diode, tested at -2.5V, is about -0.2 to -1.1 mA. This falls well within a standard required specification of -0.6 mA.

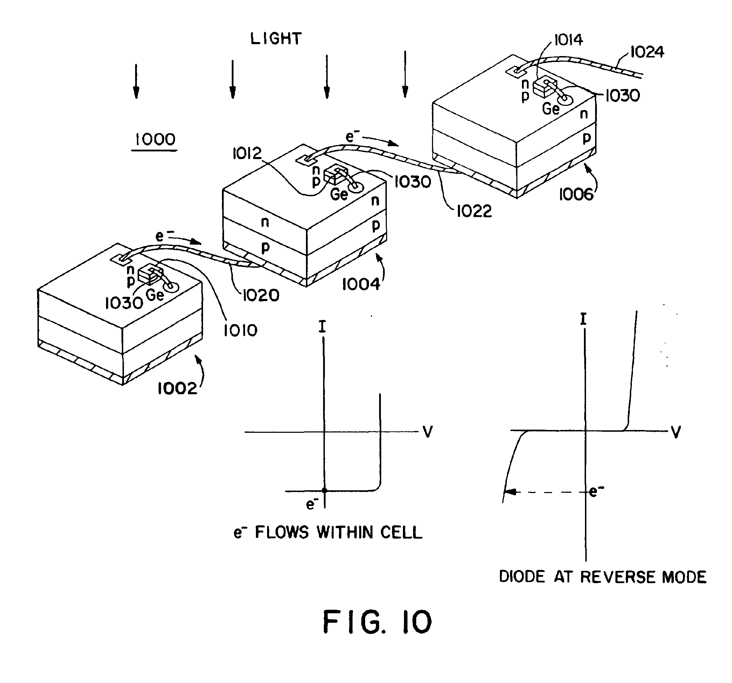

Figure 10 illustrates a device 1000 with a series of interconnected solar cell structures having bypass diodes protection in accordance to one embodiment of the present invention. In one embodiment, the solar cell structures 1002-1006 are multijunction solar cell structures as shown in Figure 7. The solar cell structures 1002-1006 further contain bypass diodes 1010-1014 and the bypass diodes 1010-1014 are deposited on the solar cell structures 1002-1006 for providing reverse bias protection. The device 1000 further includes cell interconnections 1020-1024 as coupling mechanism between individual solar cells. In one embodiment, the bypass diodes 1010-1014 are Schottky diodes wherein one terminal of the Schottky diode is connected to the substrate of the solar cell while the other terminal of the Schottky diode is connected to the front cell contacts via interconnecting wires 1030. It should be apparent to one skill in the art that other arrangements between the solar cells or solar cell structures are possible.

When the solar cell structures 1002-1006 are exposed to light, each illuminated cell, in one embodiment, becomes forward biased and generates power and/or electrical current. As discussed earlier, when the solar cell structure is in forward bias mode, the bypass diode, such as for example a Schottky diode, comes reverse biased. In operation, the solar cell structure 1002 generates electrical current and passes the current from the solar cell structure 1002 to the solar cell structure 1004 through the cell interconnection 1020. Similarly, the solar cell structure 1004 transports the electrical current to the solar cell structure 1006 via the cell connection 1022. It should be apparent to one skilled in the art that other arrangements of the solar cell structures are possible within the framework of the present invention.

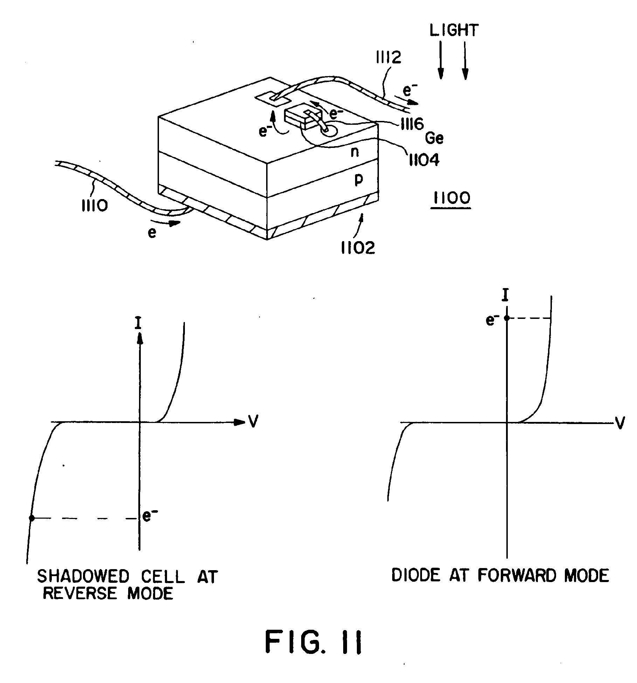

Figure 11 illustrates a solar cell structure 1100 having bypass diode for reverse bias protection when the solar cell structure 1100 is under the shadow. The solar cell structure 1100 is connected with a first cell connection 1110 for receiving electrical current and a second cell connection 1112 for sending the electrical current. The solar cell structure 1100 further includes a bypass diode 1104 for providing reverse bias protection. In one embodiment, the bypass diode 1104 is a Schottky diode.

In operation, when the solar cell structure 1102 is shadowed or not exposed to the light, the shadowed solar cell structure 1102, in one embodiment, comes the reverse biased while the bypass diode, such as a Schottky diode, comes forward biased. As illustrated in Figure 11, the bypass diode passes electrical current received from the cell connection 1110 to the stage, which is not shown in Figure 11, via the cell connection 1112. In other words, when the solar cell structure 1102 is shadowed, current through the shadowed structure 1102 becomes limited and the shadowed structure becomes reverse biased. The bypass diode connected across the shadowed structure in turn becomes forward biased. Most of the current will flow through the bypass diode 1104 rather than through the shadowed structure 1102, thereby allowing current to continue flowing through the shadowed structure 1102. In addition, the bypass diode 1104 limits the reverse bias voltage across the shadowed structure 1102, thereby protecting the shadowed structure 1102. It should be apparent to one skilled in the art that this concept can be applied to various related solar cell structure arrangements.

In the foregoing specification the invention has been described with reference to specific exemplary embodiments thereof. It will, however, be evident that various modifications and changes may be made thereto without departing from the broader scope of the invention. The specification and drawings are, accordingly, to be regarded in an illustrative rather than restrictive sense.

## Claims

1. A semiconductor device comprising:
a multijunction solar cell (100) having at least
- a P-type Germanium substrate (102) having a front surface and a back surface, said front surface being doped with arsenic so as to form a n/p homojunction (104) in the substrate,
- a back contact (138) over said back surface of said substrate,
- a plurality of layers forming a multijunction structure, including a top layer (128), deposited on a front side of the substrate (102),
- a front ohmic contact (134) deposited on the top layer (128) of the multijunction solar cell,
said multijunction solar cell (100) further comprising:
- a trough (132) that extends down to the front surface of the n/p homojunction (104) thereby exposing an As-doped region of the Ge substrate,
- a recess formed by removing portions of the n/p homojunction in the Ge substrate within the trough thereby exposing a P-type portion of the Ge substrate, such that the recess defines and surrounds an island (152) of the Ge substrate, the front surface of **the island (152) being As-doped N-type Ge,**
- a first metal contact (136) on the surface of the island (152) forming a Schottky-diode (142) as a bypass diode;
- a second metal contact (158) on the same side of the island (152) forming an ohmic contact;
- a first interconnect (140) coupled between the front contact (134) deposited on the top layer (128) and the first metal contact (136) of the bypass diode; and
- a second interconnect (162) coupled between the second contact (158) of the bypass diode and a p-type Germanium contact (160) on the front side of the substrate (102),
whereby the first and second interconnects (140,162) are jumper bars, or the first interconnect (140) runs along the walls of the trough (132) and an insulating material (144) separates the metallic interconnect (140) from the wall of the trough, and the second interconnect (162) is separated from the walls of the island (152) by an insulating material (146).

2. The circuit of Claim 1, wherein said diode contact comprises titanium.

3. The circuit of Claim 2, wherein said diode contact is made of Ti/Pd/Ag.

4. The circuit of Claim 1, wherein the Schottky diode has a forward voltage drop of about 0.3 to 0.6 volts when conducting 400 mA of forward current.

## Patentansprüche

1. Eine Halbleitervorrichtung die Folgendes aufweist:
eine Multijunction-Solarzelle (100) mit mindestens
- einem p-Typ Germaniumsubstrat (102) mit einer vorderen Oberfläche und einer hinteren Oberfläche, wobei die vordere Oberfläche mit Arsen dotiert ist, um so eine n/p Homojunction in dem Substrat zu bilden,
- einen Rückkontakt (138) über der erwähnten Rückoberfläche oder hinteren Oberfläche des Substrats,
- eine Vielzahl von Schichten, die eine Multijunction-Struktur bilden einschließlich einer oberen Schicht (129) abgeschieden auf einer Vorderseite des Substrats (102),
- einen vorderen ohmschen Kontakt (134) abgeschieden auf der oberen Schicht (128) der Multijunction-Solarzelle,
wobei die Multijunction-Solarzelle ferner Folgendes aufweist:
- einen Trog (132) der sich hinab zu der vorderen Oberfläche des n/p Homojunctions (104) erstreckt, wodurch eine As-Dotierte Zone des Ge Substrats freigelegt wird,
- eine Ausnehmung gebildet durch Entfernung von Teilen der n/p Homojunction in dem Ge Substrat innerhalb des Trogs wodurch ein t-Typ Teil des Ge Substrats freigelegt wird derart, dass die Ausnehmung eine Insel (152) aus dem Ge Substrat definiert und umgibt, wobei die vordere Oberfläche der Insel (152) As-Dotierte n-Typ Ge ist,
- einen ersten Metallkontakt (136) auf der Oberfläche der Insel (152), die eine Schottky-Diode (152) als eine Bypass-Diode formt,
- einen zweiten Metallkontakt (158) auf der gleichen Seite der Insel (152) und zwar einen ohmschen Kontakt bildend,
- eine erste Verbindung (Interconnect) (140) gekoppelt oder vorgesehen zwischen dem vorderen Kontakt (134) abgeschieden auf der oberen Schicht (128) und dem ersten Metallkontakt (136) auf der Bypass-Diode; und
- eine zweite Verbindung (Interconnect) (162) vorgesehen bzw. gekuppelt zwischen dem zweiten Kontakt (158) der Bypass-Diode und einem p-Typ Germaniumkontakt (160) auf der vorderen Seite des Substrats (102), wodurch die ersten und zweiten Verbindungen (Interconnects) (140, 162) Pfostenstecker (Jumperbars) sind, oder
die erste Verbindung (Interconnect) (140) entlang der Wände des Trogs (132) verläuft, und ein Isoliermaterial (144) die metallische Verbindung (140) von der Wand des Troges trennt und wobei die zweite Verbindung (Interconnect) (162) von den Wänden der Insel (152) durch ein Isoliermaterial (146) getrennt ist.

2. Schaltung nach Anspruch 1, wobei der erwähnte Diodenkontakt Titan aufweist.

3. Schaltung nach Anspruch 2, wobei der Diodenkontakt aus Ti/Pd/Ag hergestellt ist.

4. Schaltung nach Anspruch 1, wobei die Schottky-Diode einen Spannungsabfall in Vorwärtsrichtung von ungefähr 0.3 bis 0.6 besitzt, wenn 400 mA eines Vorwärtsstroms, das heißt eine Strömung, in Durchlassrichtung geleitet werden.

## Revendications

1. Dispositif à semi-conducteur comprenant :
une cellule solaire multijonction (100) comportant au moins
- un substrat en germanium de type P (102) ayant une surface antérieure et une surface postérieure, ladite surface antérieure étant dopée avec de l'arsenic de manière à former une homojonction n/p (104) dans le substrat,
- un contact postérieur (138) sur ladite surface postérieure dudit substrat,
- une pluralité de couches formant une structure multijonction, comprenant une couche supérieure (128), déposée du côté antérieur du substrat (102),
- un contact ohmique antérieur (134) déposé sur la couche supérieure (120) de la cellule solaire multijonction,
la cellule solaire multijonction (100) comprenant en outre :
- une dépression (132) qui s'étend vers le bas jusqu'à la surface antérieure de l'homojonction n/p (104) en exposant ainsi une région dopée au As du substrat en Ge,
- un évidement formé en éliminant des portions de l'homojonction n/p dans le substrat en Ge à l'intérieur de la dépression en exposant ainsi une portion du type P du substrat en Ge, de telle sorte que l'évidement définisse et entoure un îlot (152) du substrat en Ge, la surface antérieure de l'îlot (152) étant constituée de Ge de type N dopé au As,
- un premier contact métallique (136) sur la surface de l'îlot (152) formant une diode Schottky (142) comme diode de dérivation ;
- un second contact métallique (158) du même côté de l'îlot (152), formant un contact ohmique ;
- une première interconnexion (140) couplée entre le contact antérieur (134) déposée sur la couche supérieure (128) et le premier contact métallique (136) de la diode de dérivation ; et
- une seconde interconnexion (162) couplée entre le second contact (158) de la diode de dérivation et un contact en germanium de type p (160) sur le côté antérieur du substrat (102),
ce qui fait que les première et seconde interconnexions (140, 162) sont des barres de connexion, ou bien
la première interconnexion (140) s'étend le long des parois de la dépression (132) et une matière isolante (144) sépare l'interconnexion métallique (140) de la paroi de la dépression, et la seconde interconnexion (160) est séparée des parois de l'îlot (152) par une matière isolante (146).

2. Circuit suivant la revendication 1, dans lequel ledit contact de diode comprend du titane.

3. Circuit suivant la revendication 2, dans lequel ledit contact de diode est constitué de Ti/Pd/Ag.

4. Circuit suivant la revendication 1, dans lequel la diode Schottky connaît une chute de tension directe d'environ 0,3 à 0,6 volt lors du passage de 400 mA d'un courant direct.
